(19) Europäisches Patentamt
European Patent Office
Office européen des brevets

(11) **EP 4 446 755 A1**

(12) **EUROPEAN PATENT APPLICATION**

(43) Date of publication:
**16.10.2024 Bulletin 2024/42**

(21) Application number: 23167272.6

(22) Date of filing: **11.04.2023**

(51) International Patent Classification (IPC):
**G01R 19/10** (2006.01)   **G01R 19/00** (2006.01)
**G01R 15/18** (2006.01)   **G01R 31/08** (2020.01)
**G01R 31/52** (2020.01)   **G01R 31/54** (2020.01)
**G01R 31/55** (2020.01)

(52) Cooperative Patent Classification (CPC):
**G01R 19/10; G01R 15/181; G01R 19/0092;
G01R 31/52; G01R 31/54; G01R 31/55**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Siemens Gamesa Renewable Energy
A/S**
**7330 Brande (DK)**

(72) Inventors:
• **Hammelsvang, Jesper**
  **7400 Herning (DK)**
• **Lund, Mogens**
  **6920 Videbaek (DK)**

(74) Representative: **SGRE-Association
Siemens Energy Global GmbH & Co. KG
SE I IM P Intellectual Property
Siemenspromenade 9
91058 Erlangen (DE)**

(54) **DETECTION OF A LOOSE ELECTRICAL CONNECTION IN A WIND TURBINE**

(57)    The related invention relates to a method to measure if there is substantially equal current in a plural of N conductors (10), the method including to arrange a measuring wire (20) with a first direction coiling (30) formed of N1 loops around a first of the conductors (10) and a second direction coiling (40) formed of N2 loops around a second of the conductors (10) at the opposite looping direction relative to the first direction coiling (30), wherein number of loops N1 and N2 is selected such that the current induced in the measuring wire (20) due to inductance by the currents in the conductors (10) theoretically adds to value below a threshold T, and detect it as an inequality among the conductors (10) if the added measurement exceeds the threshold T.

Furthermore, the present invention relates to a wind turbine comprising the means for and operating according to the method.

## FIG 4

**Description**

FIELD OF THE INVENTION

The invention relates to the detection of a loose connection, or high-resistance connection, of conductors electrically connecting two electrical devices or systems. The invention is especially related to electrical devices within wind turbines.

BACKGROUND OF THE INVENTION

Wind turbines are positioned either onshore or offshore. In either case, the electrical connections are not checked frequently, often due to the turbines being relatively inaccessible. It thus would be an advantage to have an automatic and/or online detection of a loose connection. This is also the case since due to the loads and conditions, a connection could get loose over time.

It therefore is an object of the present invention to introduce cheap and easily introduced and replicable means and method to identify if there is a loose connection of conductors, which otherwise could lead to damage of the devices or wind turbine itself, such as by fire.

SUMMARY OF THE INVENTION

The object of the invention is achieved by the independent claims. The dependent claims describe advantageous developments and modifications of the invention.

The solution includes introducing a method to measure if there is substantially equal current in a plural of N conductors, the method including to arrange a measuring wire with a first direction coiling formed of N1 loops around a first of the conductors and a second direction coiling formed of N2 loops around a second of the conductors at the opposite looping direction relative to the first direction coiling, wherein number of loops N1 and N2 is selected such that the current induced in the measuring wire due to inductance by the currents in the conductors theoretically adds to value below a threshold T, and detect it as an inequality among the conductors if the added measurement exceeds the threshold T.

The total sum of loops N1 of the first direction coiling's may be such that it equals the total of sum of loops N2 of the second direction coiling's.

Each of the first and second direction loops may encircle the same number of conductors.

Each of the first and second direction loops may encircle a single conductor.

There may be double the number of first direction coiling's compared to the number of second direction coiling's, and where the individual of the first direction coiling's has half the number of loops as the individual second direction coiling's.

There may be two first direction coiling's and one second direction coiling.

Each first kind coiling may comprise two loops, and each second kind coiling comprises four loops.

The method may be used to detect a loose connection of the conductors.

The conductors may be divided into groups of three, where for each group the tree conductors are connected with a measuring wire.

The aggregated number of loops N1 of the first may equal the aggregated number of loops N2 of the second direction coiling's.

The solution further includes introducing a wind turbine comprising means to control if there is substantially equal current in a plural of N conductors, the means including arrange a measuring wire arranged with a first direction coiling formed of N1 loops around a first of the conductors and a second direction coiling formed of N2 loops around a second of the conductors at the opposite looping direction relative to the first direction coiling, wherein number of loops N1 and N2 is selected such that the current induced in the measuring wire due to inductance by the currents in the conductors theoretically adds to value below a threshold T, and detect it as an inequality among the conductors if the added measurement exceeds the threshold T.

The wind turbine may include the means for operating according to the method of any of the previous embodiments.

BRIEF DESCRIPTION OF THE DRAWINGS

Embodiments of the invention are now described, by way of example only, with reference to the accompanying drawings, of which:

Figure 1        shows a general illustration of a wind turbine.

Figure 2        shows a general illustration of the drive train within a wind turbine.

Figures 3A     and B illustrates phase shifted three-phase currents, where fig. 3A shows the currents adding to zero in an ideal system.

Figure 4        shows three conductors with a measuring wire formed with first direction coiling's looping two of the conductors, and a second direction coiling looping the third conductor.

Figure 5        shows nine conductors divided into groups of three conductors, where for each group a measuring wire is formed with first direction coiling's looping two of the conductors, and a second direction coiling looping the third conductor of the group.

Figure 6        shows nine conductors divided into groups of three conductors, where a measuring wire is formed with two first direction coiling's each looping three of the conductors, and a second direction coiling looping the three remaining conductors.

The illustration in the drawings is in schematic form. It is noted that in different figures, similar or identical elements may be provided with the same reference signs.

DESCRIPTION OF THE DRAWINGS

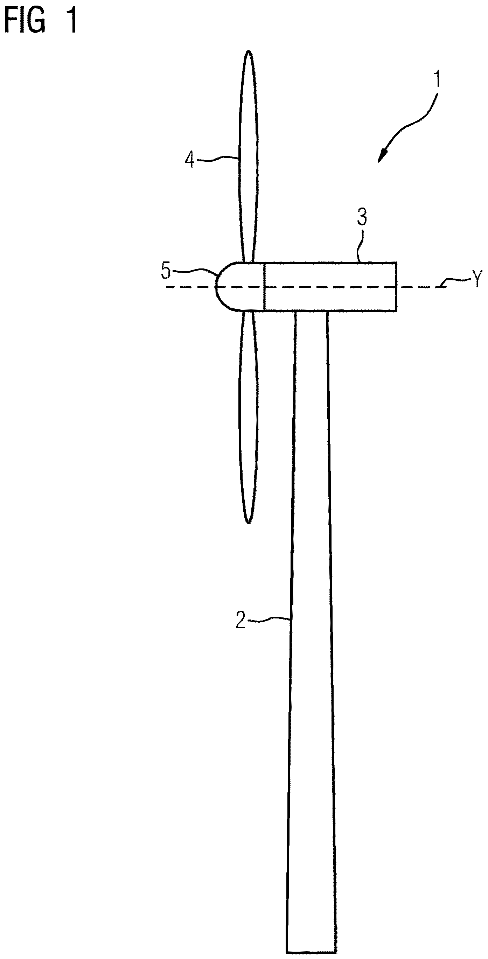

**Figure 1** shows an embodiment wind turbine 1 positioned in the water, such as the ocean. The wind turbine 1 comprises a tower 2 mounted on a non-depicted fundament. A nacelle 3 is arranged on top of the tower 2. The wind turbine 1 further comprises a wind rotor 5 having two, three or more blades 4 (in the perspective of Figure 1 only two blades 4 are visible). The wind rotor 5 is rotatable around a longitudinal rotation axis Y. The wind turbine 1 comprises an electric generator.

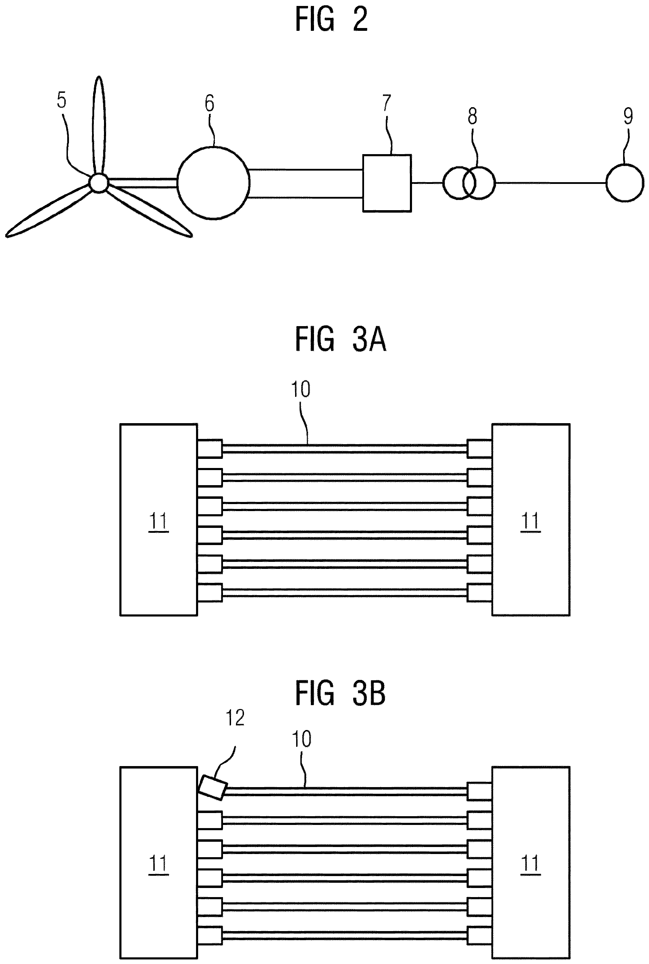

**Figure 2** schematically shows the principle of construction of the energy producing system of a wind turbine 1 showing a generator 1 connected to the rotor 5 by a shaft or drive train. A variable-voltage DC link with a capacitor is feed by the rectified voltage pulses of the generator 1, and an inverter 7, for example a force-commutated inverter, is adapted to create a defined alternating output voltage. A transformer 8 brings the alternating voltage to a suitable peak level and frequency for feeding the energy into the utility grid 9.

**Figure 3A** illustrates six conductors 10 connecting two devices 11. The devices 11 could be any electrical systems or devices where power exchange is required. In one embodiment they could be respectively a generator 6 and inverter 7 in a wind turbine 1, a wind turbine 1 in general to a grid 9, an inverter 7 to the transformer 8 etc.

In the illustration six conductors 10 are illustrated though any number more than one conductor 10 would apply to the present invention.

In the illustration the conductors 10 are connected to the devices 11 transferring a total current split between the six conductors 10. Ideally if excluding any effects of current displacement due to asymmetrical magnetic field distribution, each thus will be carrying about the same fraction of the total current in the ideal situation with equal resistivities etc. In fig. 3A all conductors are correctly connected, but in **fig. 3B** one is loosely 12 or not fully connected forming a loose or high-resistivity connection. This could form a risk, e.g., the current in the remaining conductors raising to a level where they could be heating possible to start a fire.

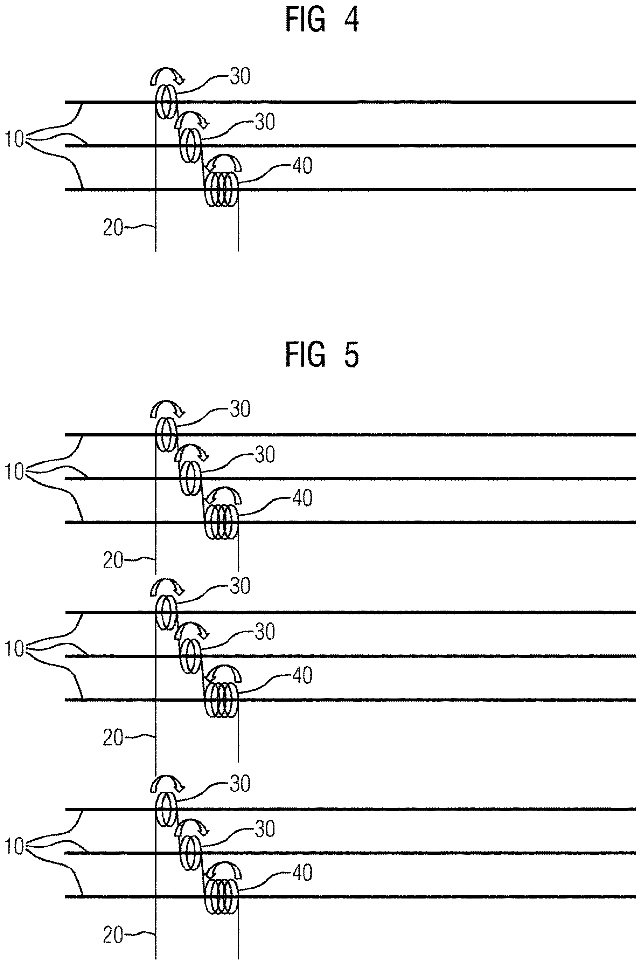

**Figure 4** illustrates a method to measure if there is substantially equal current in 3 conductors 10, though the method could be expanded to any number N conductors 10.

The method includes to arrange a measuring wire 20 with a first direction coiling 30 wrapped around a first of the conductors (10) and a second direction coiling 40 wrapped around a second of the conductors 10 at the opposite looping direction relative to the first direction coiling 30. The one of the first 30 and second 40 direction coiling's thus could be looping, or is wrapped, with N1 loops in a clockwise direction around the respective conductor 10, whereas the other of the first 30 and second 40 direction coiling's then could be looping, or is wrapped, with N2 loops in an anti-clockwise direction around the respective conductor 10.

In the illustration two first direction coiling's 30 are seen each with two loops, and the single second direction coiling 40 are seen with four loops.

More generally, any number N of conductors would apply to the present invention, just as any number of respective first 30 and second 40 direction coiling's.

The number of loops in the different first direction coiling's 30 and the different second direction coiling's 40 could also be different.

In one embodiment, the number of loops N1, N2 of the respective first 30 and second 40 direction coiling's corresponds to the number of conductors 10 they respectively loop's or is wrapped around. In the illustrated embodiment of fig. 1 the two first direction coiling's 30 each is wrapped around a single conductor 10 and each comprises N1 = 2 loops. The second direction coiling 40 is wrapped around a single conductor 10 and each comprises N2 = 4 loops. In total, the aggregated, or total, number of loops N1 of the first 30 equals the aggregated, or total, number of loops N2 of the second 40 direction coiling's

In general, the number of loops N1 and N2 is selected such that the current induced in the measuring wire 20 due to inductance by the currents in the conductors 10 theoretically adds to value below a threshold T. The method thus includes to detect it as an inequality among the conductors 10) if the added measurement exceeds the threshold T. In one embodiment T equals zero or is at least close to zero compared to the expected current of each conductor 10, such as less than 20%, or less than 10% or less than 5%.

The equation for the ideal situation taking only account on the currents within the conductors 10 and their induction of a current in the measuring wire 20, would then be:

$$\mathrm{Iw} = 2 \; \mathrm{x} \; \mathrm{I30,1} + 2 \; \mathrm{x} \; \mathrm{I30,2} - 4 \; \mathrm{x} \; \mathrm{I40,}$$

Where Iw is the current measured in the measuring wire 20, the parts $2 \times 130,1$ and $2 \times I30, 2$ is the two first 30 direction coiling's each with two loops and the respective currents I30,1 and I30,2 in the conductors 10. The part $4 \times I40$ is the four loops of the second direction coiling 40 and the current I40 of the respective conductor 10. If all currents are equal, Iw will be zero, or close to zero. In a less ideal situation if Iw > T, where T is the defined threshold possible being zero, this is an indication of an inequality.

**Figure 5** illustrates an embodiment with more than 3 conductors. In the illustration 9 conductors 10 are seen divided into groups of three. For each group the tree conductors 10 are connected with a measuring wire 20 according to the previous embodiments.

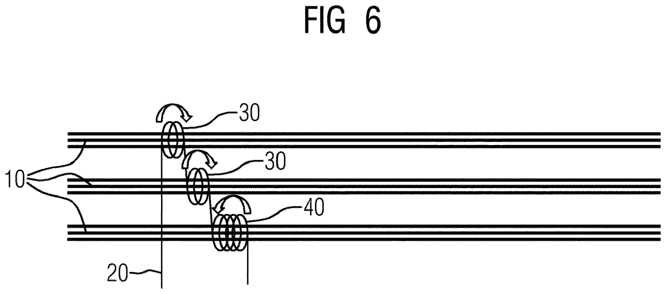

**Figure 6** shows an embodiment where there are more than 3 conductors, where, alternatively, or additionally, to forming groups of three each with a measuring wire 20 as in fig. 3, all or some of the first 30 and second 40 direction coiling's are wrapped around a plural of conductors 10.

In figure 6 each of the coiling's 30, 40 loop the same number of conductors 10. The number of loops N1, N2 of the respectively first 30 and second 40 direction coiling's are the same as in e.g. fig. 4, thus giving the same conditions.

A more general equation for the ideal situation taking only account on the currents within the conductors 10 and their induction of a current in the measuring wire 20, would then be:

$$\mathrm{Iw} = \sum_{n1} \mathrm{N1}_{n1} \; \mathrm{x} \; \mathrm{I30,n1} - \sum_{n2} 4 \; \mathrm{x} \; \mathrm{I40,n2}$$

Where Iw is the current measured in the measuring wire 20, the first part is the sum of the currents I30,n1 of the individual conductors 10 looped by first 30 direction coiling's multiplied with the respective loops $N1_{n1}$. In the same manner, the second part is the sum of the currents I40,n1 of the individual conductors 10 looped by second 40 direction coiling's multiplied with the respective loops $N2_{n2}$.

The respective number loops $N1_{n1}$ and $N2_{n2}$ of the individual conductors 10 and the number of first 30 and second 40 direction coiling's are then selected such that in case of equality of currents in the conductors 10 the measuring wire 20 current Iw ideally will be zero, or at least close to zero.

In the embodiments as illustrated in e.g. any of figs. 4-6, the total sum of loops N1 of the first direction coiling's 30 equals the total of sum of loops N2 of the second direction coiling's 40.

Further, for the illustrated embodiments each of the first 30 and second 40 direction loops encircles the same number of conductors 10.

In some not illustrated embodiments the different coiling's 30, 40 loop different number of conductors 10.

## Claims

1. Method to measure if there is substantially equal current in a plural of N conductors (10), the method including to arrange a measuring wire (20) with a first direction coiling (30) formed of N1 loops around a first of the conductors (10) and a second direction coiling (40) formed of N2 loops around a second of the conductors (10) at the opposite looping direction relative to the first direction coiling (30), wherein number of loops N1 and N2 is selected such that the current induced in the measuring wire (20) due to inductance by the currents in the conductors (10) theoretically adds to value below a threshold T, and detect it as an inequality among the conductors (10) if the added measurement exceeds the threshold T.

2.  Method according to claim 1, wherein the total sum of loops N1 of the first direction coiling's (30) equals the total of sum of loops N2 of the second direction coiling's (40) .

3.  Method according to claim 1 or 2, wherein each of the first (30) and second (40) direction loops encircles the same number of conductors (10).

4.  Method according to claim 1, 2 or 3, wherein each of the first (30) and second (40) direction loops encircles a single conductor (10).

5.  Method according to any of the preceding claims, wherein there are double the number of first direction coiling's (30) compared to the number of second direction coiling's (40), and where the individual of the first direction coiling's (30) has half the number of loops as the individual second direction coiling's (40).

6.  Method according to claim 5, wherein there are two first direction coiling's (30) and one second direction coiling (40).

7.  Method according to claim 5 or 6, wherein each first kind coiling (30) comprises two loops, and each second kind coiling (40) comprises four loops.

8.  Method according to any of the preceding claims, wherein the method is used to detect a loose connection of the conductors (10).

9.  Method according to any of the preceding claims, wherein the conductors (10) are divided into groups of three, where for each group the tree conductors (10) are connected with a measuring wire (20).

10. Method according to any of the preceding claims, the aggregated number of loops N1 of the first 30 equals the aggregated number of loops N2 of the second 40 direction coiling's.

11. Wind turbine (1) comprising means to control if there is substantially equal current in a plural of N conductors (10), the means including arrange a measuring wire (20) arranged with a first direction coiling (30) formed of N1 loops around a first of the conductors (10) and a second direction coiling (40) formed of N2 loops around a second of the conductors (10) at the opposite looping direction relative to the first direction coiling (30), wherein number of loops N1 and N2 is selected such that the current induced in the measuring wire (20) due to inductance by the currents in the conductors (10) theoretically adds to value below a threshold T, and detect it as an inequality among the conductors (10) if the added measurement exceeds the threshold T.

12. Wind turbine (1) according to claim 11, wherein it includes the means for operating according to the method of any of claims 2-10.

FIG 1

## FIG 2

## FIG 3A

## FIG 3B

# FIG 4

# FIG 5

# FIG 6

Europäisches
Patentamt

European
Patent Office

Office européen
des brevets

# EUROPEAN SEARCH REPORT

**Application Number**

EP 23 16 7272

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FR 2 971 852 A1 (NEELOGY [FR]) 24 August 2012 (2012-08-24) * page 8 – page 8; figure 6 * | 1-4,8-10 | INV. G01R19/10 |
| Y | | 11,12 | G01R19/00 |
| A | | 5-7 | G01R15/18 G01R31/08 |
| Y | CA 2 885 959 A1 (WOBBEN PROPERTIES GMBH [DE]) 10 April 2014 (2014-04-10) | 11,12 | G01R31/52 G01R31/54 |
| A | * the whole document * | 1-10 | G01R31/55 |
| A | FR 3 116 125 A1 (SAFRAN ELECTRICAL & POWER [FR]) 13 May 2022 (2022-05-13) * the whole document * | 1-12 | |
| A | US 2017/373625 A1 (ANDERSEN SØREN [DK] ET AL) 28 December 2017 (2017-12-28) * the whole document * | 1-12 | |

**TECHNICAL FIELDS SEARCHED (IPC)**

G01R
H02H
F03D

The present search report has been drawn up for all claims

| Place of search | Date of completion of the search | Examiner |
|---|---|---|
| Munich | 5 September 2023 | Ako, Thomas |

EPO FORM 1503 03.82 (P04C01)

## ANNEX TO THE EUROPEAN SEARCH REPORT
## ON EUROPEAN PATENT APPLICATION NO.

EP 23 16 7272

This annex lists the patent family members relating to the patent documents cited in the above-mentioned European search report.
The members are as contained in the European Patent Office EDP file on
The European Patent Office is in no way liable for these particulars which are merely given for the purpose of information.

05-09-2023

| Patent document cited in search report | | Publication date | Patent family member(s) | | Publication date |
|---|---|---|---|---|---|
| FR 2971852 | A1 | 24-08-2012 | NONE | | |
| CA 2885959 | A1 | 10-04-2014 | AR | 092773 A1 | 29-04-2015 |
| | | | AU | 2013327204 A1 | 23-04-2015 |
| | | | BR | 112015007321 A2 | 04-07-2017 |
| | | | CA | 2885959 A1 | 10-04-2014 |
| | | | CL | 2015000788 A1 | 10-07-2015 |
| | | | CN | 104685748 A | 03-06-2015 |
| | | | DE | 102012218067 A1 | 03-04-2014 |
| | | | DK | 2904676 T3 | 19-03-2018 |
| | | | EP | 2904676 A1 | 12-08-2015 |
| | | | ES | 2666413 T3 | 04-05-2018 |
| | | | JP | 6253656 B2 | 27-12-2017 |
| | | | JP | 2015533212 A | 19-11-2015 |
| | | | KR | 20150063530 A | 09-06-2015 |
| | | | MX | 345920 B | 24-02-2017 |
| | | | NO | 2928427 T3 | 14-07-2018 |
| | | | NZ | 706578 A | 29-04-2016 |
| | | | PL | 2904676 T3 | 29-06-2018 |
| | | | PT | 2904676 T | 09-04-2018 |
| | | | RU | 2015116877 A | 27-11-2016 |
| | | | TW | 201414921 A | 16-04-2014 |
| | | | US | 2015253369 A1 | 10-09-2015 |
| | | | WO | 2014053273 A1 | 10-04-2014 |
| | | | ZA | 201502006 B | 27-07-2016 |
| FR 3116125 | A1 | 13-05-2022 | NONE | | |
| US 2017373625 | A1 | 28-12-2017 | CN | 107250820 A | 13-10-2017 |
| | | | EP | 3245528 A1 | 22-11-2017 |
| | | | ES | 2850283 T3 | 26-08-2021 |
| | | | US | 2017373625 A1 | 28-12-2017 |
| | | | WO | 2016112915 A1 | 21-07-2016 |

EPO FORM P0459

For more details about this annex : see Official Journal of the European Patent Office, No. 12/82